# EUROPÄISCHE PATENTSCHRIFT

(11) **EP 3 072 205 B1**
(45) Veröffentlichungstag und Bekanntmachung des Hinweises auf die Patenterteilung: **17.07.2019**
(21) Anmeldenummer: 14798868.7
(22) Anmeldetag: 14.11.2014
(51) Int. Cl.: H02J 7/14, G01R 19/165, G01R 31/396, H02J 7/00

(54) **BATTERIEMANAGEMENTSYSTEM ZUR STEUERUNG EINER ENERGIESPEICHERANORDNUNG UND VERFAHREN ZUM LADEN UND ENTLADEN EINER ENERGIESPEICHERANORDNUNG**
BATTERY MANAGEMENT SYSTEM FOR CONTROLLING AN ENERGY STORAGE ASSEMBLY AND METHOD FOR CHARGING AND DISCHARGING AN ENERGY STORAGE ASSEMBLY
SYSTÈME DE GESTION DE BATTERIE POUR COMMANDER UN ENSEMBLE DE STOCKAGE D'ÉNERGIE ET PROCÉDÉ DE CHARGE ET DE DÉCHARGE D'UN ENSEMBLE DE STOCKAGE D'ÉNERGIE

(30) Priorität: 22.11.2013 DE 102013112923
(43) Veröffentlichungstag der Anmeldung: 28.09.2016
(73) Patentinhaber: H-Tech AG, 9494 Schaan (LI)
(72) Erfinder: CANADI, Samuel, 72574 Bad Urach (DE)
(74) Vertreter: Ter Meer Steinmeister & Partner
(86) Internationale Anmeldenummer: PCT/EP2014/074599
(87) Internationale Veröffentlichungsnummer: WO 2015/074964

(56) Entgegenhaltungen:
- JP-A- 2003 219 572
- JP-A- 2006 138 750
- JP-A- 2009 216 448
- US-A- 5 543 245
- US-A1- 2012 146 586

## Beschreibung

Die vorliegende Erfindung betrifft ein Batteriemanagementsystem zur Steuerung einer Energiespeicheranordnung, insbesondere zur Steuerung des Lade- bzw. Entladevorgangs einer Energiespeichervorrichtung. Darüber hinaus betrifft die Erfindung eine Energiespeicheranordnung mit mehreren elektrisch in Reihe geschalteten Speichermodulen, die von einem zuvor genannten Batteriemanagementsystem gesteuert wird. Weiter betrifft die vorliegende Erfindung ein Verfahren zum Laden bzw. Entladen einer oben genannten Energiespeicheranordnung.

Bei Energiespeichern werden zunehmend Lithium-Ionen-Akkus eingesetzt, insbesondere für Elektro- und Hybridfahrzeuge, aber auch in vielen anderen Bereichen, z.B. bei tragbaren elektronischen Geräten. Der Vorteil von Lithium-Ionen-Akkus ist die besonders hohe Energiedichte bei gleichzeitig geringem Volumen und Gewicht. Ein Nachteil von Lithium-Ionen-Akkus ist jedoch, dass diese sehr empfindlich gegen Überladung sind, so dass nur mit entsprechenden Schutzschaltungen ein Betrieb innerhalb der vorgeschriebenen Toleranzgrenzen und somit eine lange Lebensdauer der Lithium-Ionen-Akkus gewährleistet werden kann. Lithium-Ionen Akkus werden im Folgenden auch als Lithium-Ionen-Zellen bezeichnet.

Bei herkömmlichen Akkus, beispielsweise NiCd- oder NiMh-Akkus sind derartige Schutzschaltungen nicht erforderlich, da diese Akkus sehr robust sind. Im Gegensatz dazu ist der Lithium-Ionen-Akku bereits bei einer geringfügigen Überladung langfristig geschädigt. Das Gleiche gilt für eine Tiefentladung von Lithium-Ionen-Zellen, die eine nachhaltige Zerstörung der Zelle nach sich ziehen. Daher müssen die Zellen von Lithium-Ionen-Akkus regelmäßig überwacht werden, um einen reibungsfreien und sicheren Betrieb zu gewährleisten. Dazu werden Batteriemanagementsysteme eingesetzt, die dafür sorgen, dass die einzelnen Zellen nicht überladen werden und auch nicht zu stark entladen werden.

Energiespeicheranordnungen bei Elektro- und Hybridfahrzeugen, aber auch bei anderen batteriebetriebenen Vorrichtungen, sind üblicherweise aus einer Reihenschaltung aus mehreren Speichermodulen zusammengesetzt, wobei ein Speichermodul mehrere Zellen aufweisen kann. Die Zellen sind üblicherweise in sogenannten Akkupacks bzw. Sheets verbaut, wobei die einzelnen Zellen innerhalb dieser Sheets nur bedingt einzeln überwacht werden können. Innerhalb der Ackupacks bzw. Sheets sind die Zellen in Reihe und/oder parallel verschaltet. Da jedoch mehrere Sheets oder Akkupacks in Reihe geschaltet werden, lässt sich eine Überwachung der Speichermodule bzw. Sheets gewährleisten. Die einzelnen Akkupacks bzw. Speichermodule weisen dazu separate Anschlüsse auf, die ein Überprüfen der Spannung und ein Laden bzw. Entladen der in diesem Speichermodul befindlichen Zellen ermöglichen. Während eines Lade- bzw. Entladevorgangs wird die Spannung der einzelnen Speichermodule vom Batteriemanagementsystem überwacht.

Zu den wichtigsten Aufgaben eines Batteriemanagementsystems gehört die Überwachung des Lade- und Entladevorgangs einer Energiespeicheranordnung, die mehrere in Reihe geschaltete Speichermodule umfasst, wobei die Speichermodule aus mehreren zusammengeschalteten Zellen aufgebaut sind. Wie bereits oben erwähnt, weisen Speichermodule auf Lithiumbasis eine hohe Empfindlichkeit für Über- und Unterspannungen auf, die von einem Batteriemanagementsystem überwacht und verhindert werden müssen. Dazu überwacht das Batteriemanagementsystem neben dem Lade- bzw. Entladezustand auch die Temperatur und übernimmt ggf. auch die Steuerung des Ladungsausgleichs zwischen den einzelnen Speichermodulen.

Beim Einsatz von Speichermodulen auf Lithiumbasis dient das Batteriemanagementsystem als Schnittstelle zwischen den im Fahrzeug verbauten elektrischen Abnehmern bzw. Generatoren und den in der Batterie verbauten Speichermodulen. Dabei überwacht das Batteriemanagementsystem einerseits die Batterie und steuert diese Batterie in Abhängigkeit der Funktions- bzw. Betriebszustände des Fahrzeugs. So übernimmt das Batteriemanagementsystem beispielsweise die Aktivschaltung der Batterie beim Betrieb des Fahrzeugs bzw. die Standby-Regulierung, wenn das Fahrzeug nicht bewegt wird bzw. übernimmt sie den Ladevorgang, wenn die Batterie des Fahrzeugs bei Nichtbetrieb geladen wird.

Das Batteriemanagementsystem weist in Elektrofahrzeugen insbesondere Schütze auf, um eine elektrische Trennung zwischen der Batterie und den elektrischen Komponenten des Fahrzeugs zu steuern. So übernimmt beispielsweise das Batteriemanagementsystem bei einem Unfall die Funktion, dass bei einem Ansprechen von entsprechenden Sensoren des Fahrzeugs das Batteriemanagementsystem die Schütze öffnet und somit die Energiespeicheranordnung elektrisch und galvanisch vollständig vom Fahrzeug trennt.

Konventionelle Batteriemanagementsysteme überwachen neben zahlreichen anderen Funktionen den Lade- und Entladevorgang der Speichermodule einer Energiespeicheranordnung. Hierbei wird jedoch nur das Erreichen der Ladeschlussspannung bzw. der Entladeschlussspannung überwacht bzw. wird in einem Toleranzbereich vor diesen definierten Spannungsgrenzen eine Beendigung des Ladevorgangs bzw. Entladevorgangs aktiviert.

Moderne Speichermodule bzw. einzelne Zellen auf Lithiumbasis innerhalb der Speichermodule können jedoch im täglichen Einsatz Unregelmäßigkeiten aufweisen, die eine flexiblere Steuerung durch das Batteriemanagementsystem erfordern, um einerseits eine verbesserte Brauchbarkeit der angeschlossenen Verbraucher zu gewährleisten und andererseits einen verbesserten Schutz der Speichermodule bzw. eine verlängerte Lebenszeit der Speichermodule garantieren.

Es ist beispielsweise möglich, dass sich bei einer Zusammenschaltung von vielen Lithium basierten Zellen in einem Speichermodul eine der Zellen bzw. auch ein ganzes Speichermodul anders verhält, als die mit diesem Speichermodul in Reihe geschalteten anderen Speichermodule. Diese Unregelmäßigkeiten können verschiedenster Natur sein und beispielsweise auf Zustände zurückzuführen sein, die nur kurzfristig in Speichermodulen auftreten bzw. sich in Bereichen von physikalischen Größen der Speichermodule abspielen, die innerhalb von Toleranzgrenzen und insbesondere zwischen Ladeschlussspannung bzw. Entladeschlussspannung stattfinden.

Konventionelle Batteriemanagementsysteme überwachen diese Parameterverläufe bzw. Verläufe von physikalischen Größen der Speichermodule innerhalb der Ladeschlussspannung bzw. Entladeschlussspannung nicht oder nur unzureichend.

US 2012/0146586 A1 offenbart ein Batteriesatz mit einem oder mehreren Zellblöcken, in denen eine oder mehrere Sekundärbatteriezellen in Reihe und/oder in Serie geschaltet sind, und eine Steuereinheit zum Messen einer Spannung von dem einen oder der mehreren Zellblöcke zum Detektieren einer Anomalität eines Zellblocks auf der Grundlage eines Messergebnisses.

JP 2006 138750 A offenbart eine Batterieüberwachungseinrichtung mit mehreren parallel geschalteten Zellblöcken, einem Spannungsdetektor zum Erfassen einer Spannung jedes Zellblocks, einer Berechnungseinheit zum Berechnen einer Spannungsvariation der parallel geschalteten Zellblöcke, und einer Bestimmungseinheit zum Bestimmen einer Anomalität basierend auf der Berechnung der Berechnungseinheit.

JP 2009 216448 A offenbart eine Vorrichtung zum Detektieren einer Anomalität eines Batteriepacks, in welchem zwei oder mehr parallele Zellblöcke, in denen zwei oder mehr Zellen parallel geschaltet sind, in Reihe geschaltet sind, mit einer Bestimmungseinheit zum Bestimmen einer Anomalität der parallelen Zellblöcke.

Aufgabe der Erfindung ist es deshalb ein Batteriemanagementsystem zur Steuerung einer Energiespeicheranordnung bzw. ein Verfahren zum Laden bzw. Entladen einer Energiespeicheranordnung anzugeben, die die oben genannten Probleme überwinden.

Insbesondere wird mit dem erfindungsgemäßen Batteriemanagementsystem bzw. mit dem Verfahren ermöglicht, auf temporäre Unregelmäßigkeiten innerhalb der Speichermodule bzw. der Zellen beim Laden bzw. Entladen von Speichermodulen zu reagieren und den Lade- bzw. Entladevorgang der Speichermodule bzw. der gesamten Energiespeicheranordnung entsprechend zu steuern.

Die Aufgabe wird durch den Gegenstand der unabhängigen Ansprüche gelöst. Vorteilhafte Ausgestaltungen und Weiterbildungen sind Gegenstand abhängiger Ansprüche.

Die Erfindung basiert auf dem Gedanken, dass sich bei den Speichermodulen der Energiespeicheranordnung, die in Reihe geschaltet sind, beim Laden bzw. Entladen nicht immer gleichmäßige Parameterverläufe bzw. Verläufe von physikalischen Größen der Speichermodule einstellen. Abweichungen in den Parameterverläufen, auch wenn diese innerhalb des Bereichs von Entladeschlussspannung und Ladeschlussspannung liegen, werden erfindungsgemäß erfasst und bei der weiteren Steuerung der Ladung bzw. Entladung berücksichtigt.

Die Berücksichtigung einer Abweichung während eines normalen Lade- bzw. Entladevorgangs führt einerseits zu einer längeren Haltbarkeit der Speichermodule und somit der gesamten Energiespeicheranordnung. Andererseits lässt sich das Gerät mit der erfindungsgemäßen Energiespeicheranordnung dadurch länger nutzen bzw. weiternutzen, was insbesondere bei Elektrofahrzeugen von erheblicher Bedeutung ist, da die km-Leistung, die mit einer Batterieladung erzielt werden kann, das entscheidende Kriterium bei Elektrofahrzeugen ist. Ein Ausfall oder Abschalten der Energiespeicheranordnung aufgrund einer Unregelmäßigkeit beim Laden oder insbesondere beim Entladen führt zu einer Beendigung der Nutzung, was bei einem Elektrofahrzeug äußerst unangenehm ist, da der Nutzer dann nur mit externer Hilfe an sein Ziel kommt.

Erfindungsgemäß ist deshalb vorgesehen, dass das Batteriemanagementsystem eine Messeinrichtung zur Erfassung von wenigstens einem Wert einer physikalischen Größe der Speichermodule und eine Steuerungseinrichtung aufweist, die in Abhängigkeit des erfassten physikalischen Wertes wenigstens eines der Speichermodule den Entlade- bzw. Ladestrom steuert, der den Speichermodulen entnommen bzw. zugeführt wird.

Dazu überprüft die Steuerungseinrichtung, ob sich ein Wert einer physikalischen Größe eines der Speichermodule schneller verändert als die entsprechenden Werte einer physikalischen Größe der anderen Speichermodule der Energiespeicheranordnung und/oder ob sich ein Wert einer physikalischen Größe eines der Speichermodule schneller verändert als ein vorgegebener Veränderungswert für die physikalischen Größe.

Mittels eines derartigen Batteriemanagementsystems ist es folglich möglich, einen zu schnellen oder unnormalen Spannungsanstieg beim Laden bzw. einen zu schnellen oder unnormalen Spannungsabfall beim Entladen zu erkennen und darauf basierend auf den gesamten Lade- bzw. Entladevorgang einzuwirken.

Dazu enthält das Batteriemanagementsystem vorzugsweise eine Speichereinrichtung in der Werte von physikalischen Größen der Speichermodule gespeichert sind. Insbesondere können hier Werte von physikalischen Größen abgespeichert werden, um somit abzulesen, ob sich eine der gemessenen physikalischen Größen wie Spannung, Strom oder Temperatur anders verhält, als die in der Speichereinrichtung gespeicherten Vergleichswerte.

Insbesondere kann in der Speichereinrichtung ein vorgegebener Veränderungswert für die überwachte physikalische Größe abgelegt sein. Das heißt, in der Speichereinrichtung ist gespeichert, um wie viel sich die Spannung, die Temperatur oder der Strom jeweils pro Zeiteinheit verändern kann bzw. darf.

Sollte eine Abweichung der gemessenen Werte an den Speichermodulen untereinander auftreten bzw. eine Abweichung der gemessenen physikalischen Werte der Speichermodule im Vergleich zu den in der Speichereinrichtung gespeicherten Werten der physikalischen Größen auftreten, wird von der Steuerungseinrichtung entsprechend auf den Entladestrom bzw. Ladestrom eingewirkt.

Dadurch kann verhindert werden, dass der Ladevorgang bzw. Entladevorgang unverändert beibehalten wird und somit bei einem schnelleren bzw. zu schnellem Spannungsanstieg die Ladeschlussspannung sehr schnell erreicht wird und demzufolge gegebenenfalls keine vollständige Ladung der Speichermodule möglich ist, da dann das herkömmliche Batteriemanagementsystem den Ladevorgang beenden würde.

Das erfindungsgemäße Batteriemanagementsystem ist zur Beeinflussung des Lade- bzw. Entladestroms an eine Vorrichtung zur Strombegrenzung gekoppelt oder enthält eine Vorrichtung zur Strombegrenzung. Basierend auf dem Vergleich des gemessenen Werts der physikalischen Größe mit den entsprechenden Werten der anderen Speichermodule bzw. mit dem vorgegebenen Veränderungswert für die physikalische Größe aus der Speichereinrichtung wird die interne oder externe Vorrichtung zur Strombegrenzung in Abhängigkeit von Steuersignalen der Steuerungseinrichtung aktiviert bzw. deaktiviert um somit den Ladestrom bzw. den Entladestrom, der den Speichermodulen der Energiespeicheranordnung zugeführt wird bzw. entnommen wird, zu begrenzen.

In einer weiteren Ausgestaltung ist es möglich, dass das Batteriemanagementsystem alternativ zur Steuerung einer internen oder externen Vorrichtung zur Strombegrenzung ein Steuersignal ausgibt, welches von einer externen Steuerungseinrichtung des elektrischen Verbrauchers oder eines Ladegeräts empfangen wird und die Last bzw. den Ladevorgang entsprechend beeinflusst. Somit ist es beispielsweise möglich, dass bei einer Abweichung des gemessenen Werts der physikalischen Größe von den anderen entsprechenden Werten bzw. vom abgespeicherten Veränderungswert von der Steuerungseinrichtung ein Steuersignal an den Bordcomputer eines Elektrofahrzeugs ausgegeben wird, um diesen darüber zu informieren, dass eine Unregelmäßigkeit in der Energiespeicheranordnung aufgetreten ist und beispielsweise nur noch ein reduzierter Strom für die Last zur Verfügung steht.

Durch die Reduzierung und/oder vollständige Abschaltung des Entlade-/Ladevorgangs bei einer festgestellten Unregelmäßigkeit oder Anomalie wird dem Speichermodul die Gelegenheit gegeben mit geringerer Last bzw. mit geringerem Ladestrom zu einem Zustand zurückzufinden, der wieder im Normalbereich liegt. Häufig werden die unnormalen Zustände bei Speichermodulen insbesondere dadurch erreicht, dass mit Maximalladeströmen bzw. Entladeströmen gearbeitet wird, wodurch die Speichermodule an den Rand ihrer Belastungsgrenzen herangeführt werden. Weitere Gründe für das Auftreten von temporären Unregelmäßigkeiten beim Laden bzw. Entladen können Herstellungstoleranzen oder Alterung der Zellen in den Speichermodulen sein. Darüber hinaus kann eine Unregelmäßigkeit auch durch den physikalischen Aufbau und einer daraus resultierenden unterschiedlichen Belastung der einzelnen Zellen bzw. durch einen Teildefekt (z.B. einzelne Zellen innerhalb eines Speichermoduls durch mechanische Überlastung elektrisch getrennt) entstehen. Wenn dann erfindungsgemäß die Belastung für das Speichermodul bzw. die gesamte Energiespeicheranordnung temporär reduziert wird bzw. temporär ausgesetzt wird, hat das einzelne Speichermodul in dem die Unregelmäßigkeit aufgetreten ist, die Möglichkeit wieder in einen stabilen Zustand zurückzukehren.

Dazu wird vom erfindungsgemäßen Batteriemanagementsystem vorzugsweise permanent der Wert einer physikalischen Größe erfasst. Sollte der abweichende bzw. unnormale Wert der physikalischen Größe in einen normalen Bereich zurückkehren, kann die Lastbegrenzung bzw. die Begrenzung des Ladestroms wieder aufgehoben werden. Hierbei kann vorgesehen sein, dass das Batteriemanagementsystem insbesondere das betroffene Speichermodul, in dem die Unregelmäßigkeit aufgetreten ist, weiter überwacht.

Sollte die Unregelmäßigkeit bei normaler Belastung bzw. bei normalem Laden erneut auftreten, ist erfindungsgemäß vorgesehen, mit einer anderen bzw. verstärkten Maßnahme dieser Unregelmäßigkeit entgegenzuwirken.

Dazu ist beispielsweise vorgesehen, dass nach einer Lastbegrenzung bei der ersten Unregelmäßigkeit und einem erneuten Auftreten einer Unregelmäßigkeit eine entweder stärkere Lastbegrenzung eingestellt wird bzw. für eine voreingestellte Zeit eine Lastunterbrechung vorgesehen ist. Es ist auch möglich, bei wiederkehrender Unregelmäßigkeit beim gleichen Speichermodul, die Zeiten zu verlängern, nach denen überprüft wird, ob die Unregelmäßigkeit noch vorliegt.

Erfindungsgemäß ist vorgesehen, dass die Steuerungseinrichtung überprüft, ob sich ein Spannungswert eines der Speichermodule schneller verändert als die Spannungswerte der anderen Speichermodule der Energiespeicheranordnung bzw. ob sich ein Spannungswert eines der Speichermodule schneller verändert als ein in der Speichervorrichtung gespeicherter Spannungsveränderungswert. Sollte beim Laden eine Abweichung oder Unregelmäßigkeit festgestellt werden, das heißt, an einem der Speichermodule wurde ein Spannungsveränderungswert überschritten oder die Spannung steigt hier schneller als bei den anderen Speichermodulen, wird eine Ladestrombegrenzung für alle Speichermodule aktiviert.

Wird andererseits beim Entladen eine unnormale Spannungsänderung festgestellt, d.h. die Spannung fällt an einem Speichermodul schneller ab, als bei den anderen Speichermodulen, wird eine Entladestrombegrenzung für alle Speichermodule aktiviert wird. Das heißt, erfindungsgemäß ist vorgesehen, sowohl einen schnelleren Anstieg der Spannung bzw. grundsätzlich des Werts einer physikalischen Größe bzw. auch ein schnelleres Abfallen einer Spannung bzw. eines Werts einer physikalischen Größe an einem der Speichermodule zu überwachen und demzufolge eine Ladestrombegrenzung bzw. eine Entladestrombegrenzung für alle Speichermodule zu aktivieren.

Vorzugsweise deaktiviert die Steuerungseinrichtung die Ladestrombegrenzung nachdem der Spannungsänderungswert wieder mit den Werten der anderen Speichermodule oder den gespeicherten Werten übereinstimmt.

Es ist auch vorzugsweise möglich, dass die Steuerungseinrichtung die Entladestrombegrenzung nach Unterschreiten der Spannungsänderung oder eines anderen vorbestimmten Spannungsänderungswerts deaktiviert. Das heißt, in dem Fall, in dem der Anstieg bzw. der Abfall des überwachten Werts der physikalischen Größe wieder in einen Normalbereich zurückkehrt, wird die Ladestrombegrenzung bzw. die Entladestrombegrenzung deaktiviert.

Alternativ bzw. zusätzlich kann vorgesehen sein, die Ladestrom- bzw. Entladestrombegrenzung beizubehalten oder stufenweise zu verringern. Wenn die Ladestrom- bzw. Entladestrombegrenzung beibehalten bleibt, muss bspw. die Energiespeicheranordnung zuerst einer Wartung unterzogen werden, um wieder die ursprünglich anwendbaren Ladeströme bzw. Entladeströme freizuschalten.

Alternativ bzw. zusätzlich kann vorgesehen sein, dass für verschiedene Ladestromwerte in der Speichervorrichtung verschiedene Spannungsänderungswerte gespeichert sind und/oder für verschiedene Entladestromwerte verschiedene Spannungsänderungswerte abgespeichert sind und die Begrenzung der Lade- bzw. Entladeströme abhängig von den Ladestromwerten bzw. Entladestromwerten eingestellt wird. Wenn mit einem sehr hohem Entladestrom gearbeitet wird, wird die Begrenzung bei einer Unregelmäßigkeit stärker sein, als bei einem niedrigeren Entladestrom, da durch einen sehr hohen Entladestrom und einer Unregelmäßigkeit, die Wahrscheinlichkeit einer Schädigung des Speichermoduls größer ist, als bei einem geringen Entladestrom, bei dem bei einer Unregelmäßigkeit der Entladestrom geringer begrenzt werden muss.

Dies hat den Vorteil, dass bei hohen Ladeströmen bzw. hohen Entladeströmen selbst bei kleineren Abweichungen im Spannungsänderungswert reagiert werden kann. Bei vergleichsweise kleinen Ladestromwerten bzw. Entladestromwerten ist hingegen eine Abweichung des Spannungsänderungswerts für längere Zeit hinnehmbar, sodass dann die Steuerungseinrichtung noch nicht anspricht.

Die Aufgabe wird auch durch eine Energiespeicheranordnung mit mehreren elektrisch in Reihe geschalteten Speichermodulen mit einem oben beschriebenen Batteriemanagementsystem gelöst.

Darüber hinaus wird die Aufgabe auch durch ein Verfahren zum Laden und Entladen einer Energiespeicheranordnung gelöst, wobei die Energiespeicheranordnung mehrere elektrisch in Reihe geschaltete Speichermodule aufweist.

Das Verfahren umfasst die Schritte, Erfassen von wenigstens einem Wert einer physikalischen Größe des Speichermoduls; Überprüfen, ob sich ein Wert einer physikalischen Größe eines der Speichermodule schneller verändert als ein Wert der physikalischen Größe der anderen Speichermodule der Energiespeicheranordnung oder ob sich ein Wert einer physikalischen Größe eines der Speichermodule schneller verändert als ein vorgegebener Veränderungswert für eine physikalische Größe und Steuern des Entladestroms bzw. Ladestroms, der den Speichermodulen entnommen bzw. zugeführt wird, in Abhängigkeit der Überprüfung.

Durch das erfindungsgemäße Batteriemanagementsystem wird den Zellen bzw. den Speichermodulen bei Unregelmäßigkeiten eine Möglichkeit gegeben, wieder in ihren Normalbereich zurückzukehren ohne die Energiespeicheranordnung vollständig abzuschalten und somit eine Weiternutzung des Geräts oder Elektrofahrzeugs zu gewährleisten.

Im Folgenden wird anhand von Figuren die vorliegende Erfindung näher erläutert. In den Zeichnungen zeigt:
Fig. 1 einen Schaltplan eines ersten erfindungsgemäßen Batteriemanagementsystems;
Fig. 2 einen Schaltplan eines Batteriemanagementsystems nach einem zweiten Ausführungsbeispiel;
Fig. 3 ein Flussablaufdiagramm für den Ladevorgang einer Energiespeicheranordnung mit einem erfindungsgemäßen Batteriemanagementsystem;
Fig. 4 ein Flussablaufdiagramm eines Entladevorgangs einer Energiespeicheranordnung mit einem erfindungsgemäßen Batteriemanagementsystem;
Fig. 5 ein Flussablaufdiagramm eines weiteren Ausführungsbeispiels der vorliegenden Erfindung.
Fig. 6 ein Diagramm zur Darstellung der Ladung von 100% funktionsfähigen bzw. teilweise defekten Energiespeicheranordnungen.
Fig. 7 Spannungs- und Stromverläufe zur Darstellung der Erfindung beim Entladen.
Fig. 8 Spannungs- und Stromverläufe zur Darstellung der Erfindung beim Laden.

### Detaillierte Figurenbeschreibung

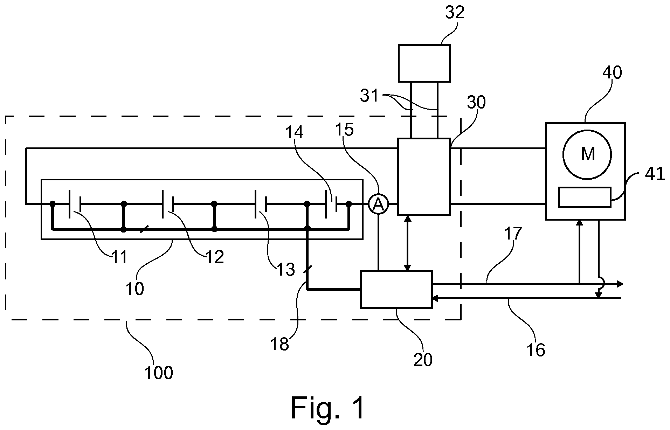

Figur 1 zeigt ein Batteriemanagementsystem 100 zur Steuerung einer Energiespeicheranordnung 10. Die Energiespeicheranordnung 10 umfasst Speichermodule 11, 12, 13 und 14. Diese sind in diesem Ausführungsbeispiel in Reihe geschaltet. In den Speichermodulen 11, 12, 13 und 14 sind mehrere Zellen in Reihe bzw. parallel geschaltet, wobei die einzelnen Speichermodule in der Energiespeicheranordnung 10 dann in Reihe geschaltet werden. Die Verschaltung der einzelnen Zellen innerhalb der Speichermodule hat dann einen Einfluss auf die an den Außenanschlüssen der Speichermodule anliegende Spannung. Für die Erläuterung bzw. Ausführung dieser Erfindung ist es jedoch nicht erheblich, in welcher Form die einzelnen Zellen innerhalb der Speichermodule 11, 12, 13 und 14 verschaltet sind. Die in Reihe geschalteten Speichermodule 11, 12, 13 und 14 können beliebig viele parallel geschaltete Zellen umfassen, da sich parallel geschaltete ideale Zellen wie eine einzige große Zelle verhalten.

Die Energiespeicheranordnung 10 ist mit einer Steuerungseinrichtung 20 verbunden. Die Steuerungsreinrichtung 20 weist eine Spannungsüberwachungsfunktionalität auf, die die Spannung über jedem Speichermodul 11, 12, 13 und 14 erfasst. Dazu ist die Steuerungseinrichtung 20 über einen Spannungserfassungsbus 18 mit den einzelnen Speichermodulen 11, 12, 13 und 14 verbunden. Weiter umfasst das Batteriemanagementsystem einen Amperemeter bzw. eine Einrichtung zur Strommessung 15. Dieser Amperemeter 15 ist in eine Zuführleitung geschaltet, um somit den Lade- bzw. Entladestrom zu messen und diesen Wert der Steuerungseinrichtung 20 zuzuführen.

Die Steuerungseinrichtung 20 kann darüber hinaus auch die Einrichtung zur Strommessung 15 anweisen, wann ein Stromwert erfasst bzw. wann er an die Steuerungseinrichtung 20 zu übertragen ist. D.h. die Erfassungsperiode kann eingestellt werden.

Zum erfindungsgemäßen Batteriemanagementsystem gehört in einer Ausgestaltung auch eine Strombegrenzungseinheit 30. Diese Strombegrenzungseinheit 30 ist in beide Zuleitungen zur Energiespeicheranordnung 10 geschaltet und wird von der Steuerungseinrichtung 20 gesteuert. Die Steuerungseinrichtung 20 umfasst darüber hinaus einen Eingang 16, über den Signale von einem oder mehreren externen Systemen bzw. von einer Last empfangen werden. Darüber hinaus weist die Steuerungseinrichtung 20 einen Ausgang 17 auf, über den Signale an externe Systeme bzw. an eine Last 40 übertragen werden.

Die Last 40, die von der Energiespeichereinrichtung 10 gespeist wird, kann beispielsweise ein Elektromotor sein. Wie in Figur 1 dargestellt, kann die Last 40 neben dem eigentlichen Verbraucher M auch eine Steuereinheit 41 umfassen, die Signale von der Steuerungseinrichtung 20 empfängt, neben Signalen von weiteren externen Einheiten. Außerdem gibt die Steuereinheit 41 in der Last 40 Signale ab, die u.a. zur Steuerungseinrichtung 20, als auch an externe Komponenten übertragen werden.

Die Strombegrenzungseinheit 30 weist auch Anschlüsse 31 auf, über die beim Ladevorgang die Energiespeicheranordnung 10 geladen wird. Die Anschlüsse 31 können alternativ auch außerhalb der Strombegrenzungseinheit 30 angeordnet sein, um beim Laden einen Ladestrom von einem Ladegerät 32 zuzuführen.

In der Strombegrenzungseinheit 30 sind vorzugsweise steuerbare Schalter enthalten, über die der zugeführte Ladestrom bzw. der entnommene Entladestrom gesteuert werden kann. Dazu lassen sich einerseits die Schalter zeitlich takten, so dass bezogen auf eine Zeiteinheit die Strommenge (Ladungsmenge) reduziert werden kann.

Am einfachsten lassen sich die Schalter zur Strombegrenzung öffnen, so dass kein Strom entnommen werden kann.

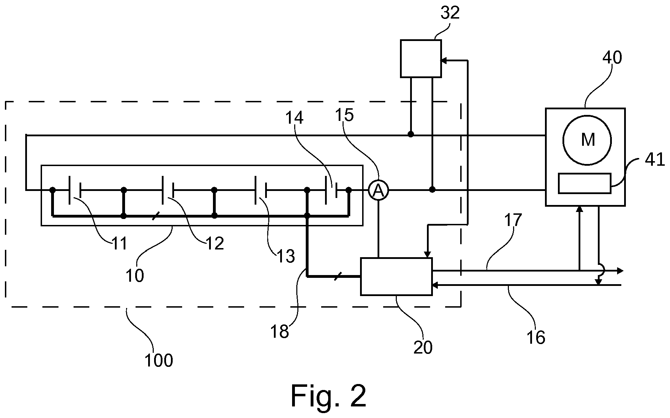

Figur 2 zeigt eine alternative Ausgestaltung eines Batteriemanagementsystems. Die Energiespeicheranordnung 10 ist in dieser alternativen Ausgestaltung analog zur Energiespeicheranordnung gemäß Fig. 1 aufgebaut. Gleiches gilt für die Einrichtung zur Strommessung 15 bzw. für die Steuerungseinrichtung 20. Die Steuerungseinrichtung 20 in der alternativen Ausgestaltung kommuniziert mit dem Ladegerät 32 bzw. mit der Last 40. D.h. im zweiten Ausführungsbeispiel des erfindungsgemäßen Batteriemanagementsystems ist keine Einrichtung zur Strombegrenzung vorhanden, da die Steuerungseinrichtung 20 direkt mit dem Ladegerät bzw. mit der Last und deren Steuereinheiten kommuniziert und somit sehr detailliert auf die Begrenzung des Ladestroms bzw. des Entladestroms einwirken kann.

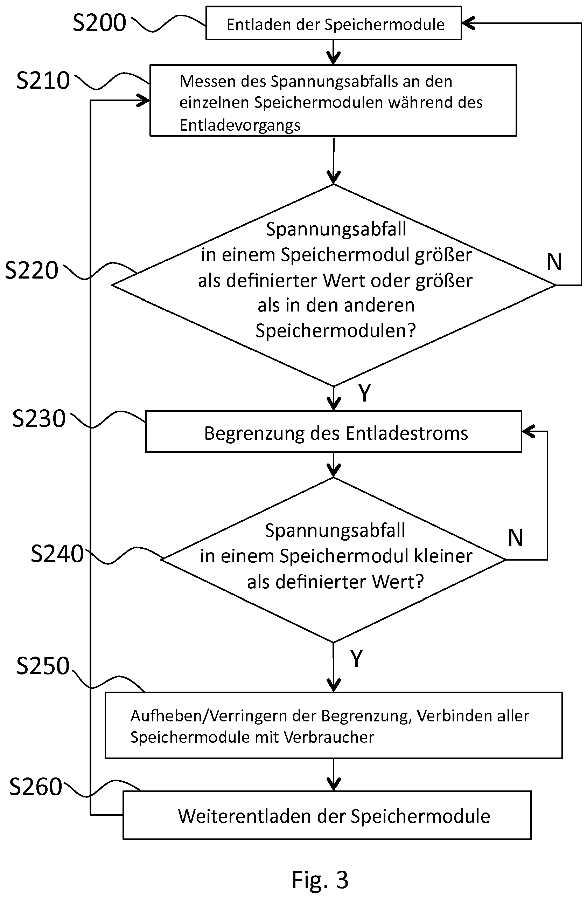

Figur 3 zeigt ein Flussablaufdiagramm, in dem das Verfahren zur Steuerung des Entladevorgangs der Speichermodule beschrieben ist. Im Schritt S200 werden die Speichermodule entladen. Nach dem Beginn des Entladevorgangs, sprich nach dem Einschalten der Last, wird der Spannungsabfall an den einzelnen Speichermodulen 11, 12, 13 und 14 permanent oder periodisch gemessen und über den Bus 18 der Steuerungseinrichtung 20 zugeführt. Die Steuerungseinrichtung 20 wandelt die erfassten Spannungen in digitale Werte um und vergleicht diese Spannungswerte mit Werten, die im Speichermodul der Steuerungseinrichtung 20 gespeichert sind bzw. in einer externen (nicht dargestellten) Speicheranordnung abgelegt sind.

Alternativ bzw. zusätzlich überprüft die Steuerungseinrichtung 20, ob der Spannungsabfall in einem der Speichermodule 11, 12, 13 oder 14 stärker bzw. größer ist als in anderen Speichermodulen 11, 12, 13 und 14. Sollte kein unnormaler Spannungsabfall erkannt werden, der größer ist als ein definierter Wert bzw. größer ist als in den anderen Speichermodulen, werden die Speichermodule weiter entladen.

Stellt die Steuerungseinrichtung 20 jedoch einen derartigen unnormalen Spannungsabfall fest, wird ein Signal an die Strombegrenzungseinheit 30 bzw. an die Last 40 bzw. deren Steuereinheit 41 ausgegeben, wodurch der Entladestrom begrenzt wird.

Wenn das Signal von der Steuerungseinrichtung 20 zur Anzeige einer Unregelmäßigkeit an die Last 40 gesendet wird, kann die Steuereinheit 41 der Last 40 die Drehzahl des Motors begrenzen, so dass dadurch der entnommene Strom (Entladestrom) reduziert wird.

Wenn das Signal von der Steuerungseinrichtung 20 zur Anzeige einer Unregelmäßigkeit an die Strombegrenzungseinheit 30 gesendet wird, kann diese durch einen gepulsten Schalter die Stromentnahme, also den Entladestrom, begrenzen. Im Extremfall kann die Strombegrenzungseinheit 30 die Stromentnahme vollständig unterbrechen, indem die Strombegrenzungseinheit 30 die Leitungen zur Last unterbricht, bspw. mittels einem oder mehrerer Schalter.

Wenn dann bspw. nach einer vorbestimmten Zeit tₚ der gemessene Spannungsabfall in dem Speichermodul, in dem die Unregelmäßigkeit aufgetreten ist, wieder geringer ist als ein definierter Wert, welches im Schritt S240 überprüft wird, gibt die Steuerungseinrichtung 20 ein Signal an die Lasteinheit 40 bzw. die Strombegrenzungseinheit 30 aus, um die Begrenzung der Last wieder aufzuheben.

Sollte der Spannungsabfall bei der Überprüfung im Schritt S240 nicht kleiner sein als ein definierter Wert, wird die Begrenzung des Entladestroms in Schritt S230 beibehalten. Es ist zwar nicht dargestellt aber möglich, dann die Begrenzung zu verstärken. Wenn die Überprüfung positiv verläuft wird nach dem Aufheben S250 der Begrenzung den Speichermodulen wieder unbegrenzt Ladung entnommen S260, wobei im Schritt S210 weiter eine permanente oder periodische Überprüfung des Spannungsabfalls in den einzelnen Speichermodulen während des Entladevorgangs vorgenommen wird.

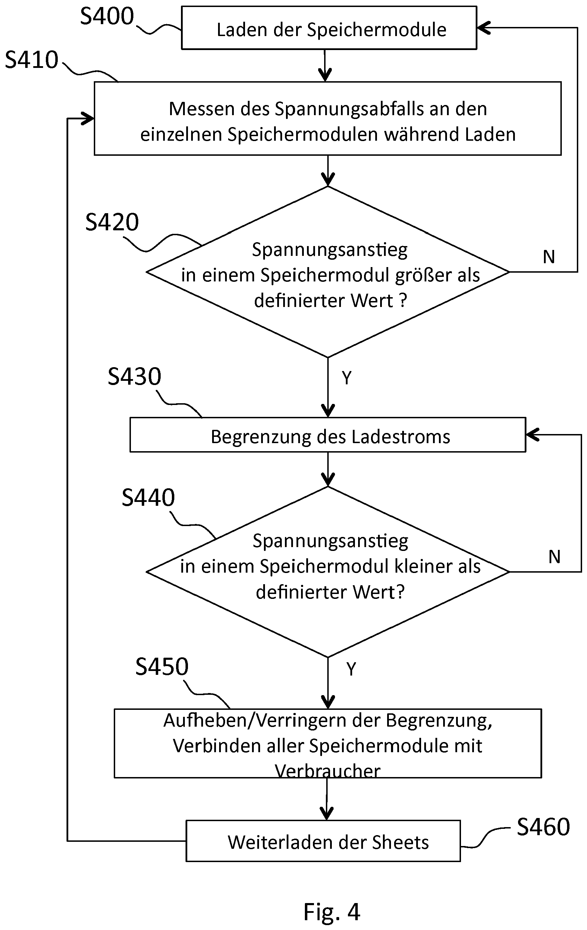

In Figur 4 ist ein Flussablaufdiagramm eines Ladevorgangs einer Energiespeicheranordnung 10 mit einem erfindungsgemäßen Batteriemanagementsystem 100 gezeigt. In Schritt S400 werden die Speichermodule geladen bzw. der Ladeprozess wird gestartet. In S410 wird die Spannung an den einzelnen Speichermodulen während des Ladens über den Bus 18 erfasst und erfasste Spannungswerte an die Steuerungseinrichtung 20 übertragen. In Schritt S420 wird ein Spannungsanstieg in den einzelnen Speichermodulen überprüft. Insbesondere wird in S420 überprüft, ob der Spannungseinstieg in einem der Speichermodule 11, 12, 13 oder 14 größer ist als ein definierter Wert, der in einer Speicheranordnung in der Steuerungseinrichtung 20 abgelegt ist bzw. ob ein Spannungsanstieg in einem der Speichermodule 11, 12, 13 oder 14 größer ist als ein Spannungsanstieg in den anderen Speichermodulen 11, 12, 13 oder 14. Ist dies nicht der Fall, wird zum Schritt S400 zurückgekehrt und die Speichermodule werden weiter geladen.

Wird bei der Überprüfung S420 festgestellt, dass der Spannungsanstieg in einem der Speichermodule größer ist als ein definierter Wert oder als in den anderen Speichermodulen wird der Ladestrom im Schritt S430 begrenzt. Dies kann einerseits dadurch passieren, dass die Steuerungseinrichtung 20 ein Signal an die Strombegrenzungseinheit 30 ausgibt und diese über eine Taktung in der Stromzufuhr die Ladungsmenge, die der Energiespeicheranordnung 10 zugeführt wird, begrenzt.

Alternativ gibt die Steuerungseinrichtung 20 gemäß dem zweiten Ausführungsbeispiel in Figur 2 ein Signal an das Ladegerät 32 zur Reduzierung des Ladestroms aus. Danach wird in S440 überprüft, ob der Spannungsanstieg in dem betroffenen Speichermodul, in dem zuvor der Spannungsanstieg außerhalb eines definierten Bereichs aufgetreten ist, kleiner ist als ein definierter Wert. Dieser definierte Wert für die Aufhebung der Begrenzung kann mit dem oberen definierten Wert in S420 für die Aktivierung der Begrenzung übereinstimmen. Die Werte können jedoch auch verschieden sein. So kann die Aktivierung in S420 schneller, also bei einem kleineren Wert des Spannungsanstiegs erfolgen, als die Aufhebung der Begrenzung in S440.

Ist der Spannungsanstieg dann bei der Überprüfung in S440 kleiner als ein definierter Wert bzw. kleiner oder gleich, wie in den anderen Speichermodulen, wird die Begrenzung des Ladestroms aufgehoben S450 und die Speichermodule werden normal weiter geladen. Auch hier kann die Begrenzung stufenweise auf Normalniveau zurückgeführt werden. Ist der Spannungsanstieg durch die Begrenzung des Ladestroms in dem betroffenen Speichermodul jedoch nicht reduziert worden, wird die Begrenzung des Ladestroms beibehalten S430 oder verstärkt. In einer besonderen Ausgestaltung wird eine Begrenzung beibehalten, bis die Energiespeicheranordnung einer Wartung unterzogen wird.

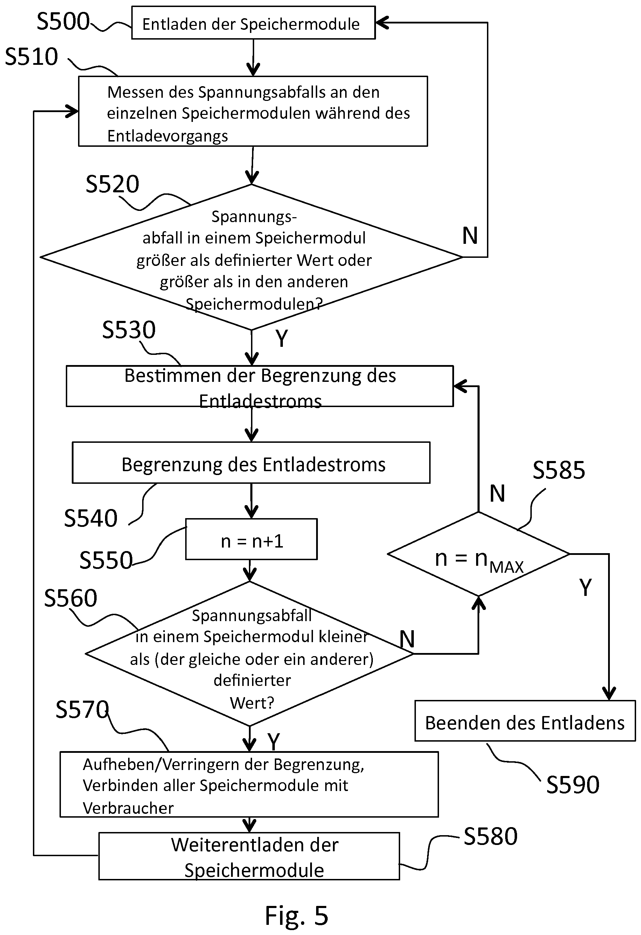

Ein Ausführungsbeispiel bei dem die Höhe der Begrenzung des Ladestroms bzw. der Begrenzung des Entladestroms bzw. auch die Anzahl der Überprüfungen berücksichtigt wird, ist in Figur 5 dargestellt.

Darüber hinaus ist in dem Flussablaufdiagramm gemäß Fig. 5 dargestellt, die Häufigkeit der Begrenzung des Ladestroms aufgrund einer Unregelmäßigkeit zu erfassen, um einem Totalausfall der Speichermodule vorzubeugen, wenn ein einmaliges oder mehrmaliges Begrenzen des Ladestroms bzw. Entladestroms nicht ausreicht, den unnormalen Spannungsanstieg bzw. Spannungsabfall aufzuhalten und das Verhalten des betroffenen Speichermoduls in den Normalbereich zurückzuführen.

| Entlade/Ladestrom | Reduktion des Entladestroms/Ladestroms um | 1. Unregelmäßigkeit (Absenkung, Zeit bis zur erneuten Messung | 2. Unregelmäßigkeit (Absenkung, Zeit bis zur erneuten Messung) | 3. Unregelmäßigkeit (Absenkung, Zeit bis zur erneuten Messung) | 4. Unregelmäßigkeit (Absenkung und Zeit bis zur erneuten Messung) |
|---|---|---|---|---|---|
| 1A | 10% | 10%+10sek | 20%+20sek | 50%+50sek | abschalten |
| 2A | 20% | 20%+10sek | 40%+40sek | abschalten | |
| 3A | 30% | 30%+10sek | abschalten | | |

Im Ausführungsbeispiel gemäß Fig. 5 wird anhand des Entladevorgangs der Speichermodule beschrieben, dass die Begrenzung des Entladestroms bei Feststellen einer Unregelmäßigkeit bzw. einer Unregelmäßigkeit stufenweise bzw. in Abhängigkeit der absoluten Größe des Entladestroms vorgenommen wird. Das heißt, in allen zuvor beschriebenen Ausführungsbeispielen ist es möglich, die Höhe der Begrenzung des Entladestroms davon abhängig zu machen, wie hoch der Entladestrom absolut gesehen ist. Das heißt, bei einem absolut gesehen sehr hohen Entladestrom wird eine stärkere Begrenzung vorgenommen als bei einem geringeren Entladestrom. Ein weiterer Faktor, der in diesem Ausführungsbeispiel beschrieben wird und sich auch auf alle anderen Ausführungsbeispiele übertragen lässt, ist die Bestimmung der Zeit tₚ, die abgewartet wird, bis wieder überprüft wird, ob eine Unregelmäßigkeit in dem betroffenen Speichermodul noch vorherrscht.

Somit wird sichergestellt, dass bei einem hohen Entladestrom die Zelle bzw. das Speichermodul ausreichend Zeit hat, sich durch die Begrenzung des Entladestroms bzw. durch die vollständige Abschaltung des Entladestroms von der Unregelmäßigkeit zu erholen.

In Schritt S500 wird mit dem Entladevorgang der Speichermodule begonnen, beispielsweise indem der Fahrer eines Elektromobils das Gaspedal betätigt und somit den Motor anlaufen lässt, der dann einen Strom benötigt, der aus der Energiespeicheranordnung 10 entnommen wird. Während dieses Entladevorgangs wird der Spannungsabfall an den einzelnen Speichermodulen im Schritt S510 überprüft oder gemessen. Dies wird über den Bus 18, der an den jeweiligen Anschlussklemmen der einzelnen Speichermodule 11, 12, 13 und 14 angeschlossen ist, vorgenommen, wobei entsprechende Spannungswerte an die Steuerungseinrichtung 20 übertragen werden. Die Steuerungseinrichtung 20 überprüft im Schritt S520, ob ein Spannungsabfall in einem der Speichermodule größer ist als ein definierter Wert bzw. ob ein Spannungsabfall in einem Speichermodul größer ist als in den anderen Speichermodulen. Sollte dies nicht der Fall sein wird, der Entladeprozess im Schritt S500 fortgesetzt. Bei Feststellung einer Unregelmäßigkeit im Schritt S520 wird in der Steuerungseinrichtung 20 beispielsweise in einer Tabelle bzw. unter Anwendung einer Formel bestimmt, wie stark der Entladestrom begrenzt wird.

Dazu ist beispielsweise vorgesehen, bei einem Entladestrom von beispielsweise 1A eine Begrenzung von 10% des Entladestroms einzustellen. D.h. die Last wird um 10% reduziert bzw. wird der Last nur noch 90%, also 0,9A zur Verfügung gestellt. In einem anderen Ausführungsbeispiel ist es möglich, beim Entladestrom von 2A eine Begrenzung des Entladestroms von 20% vorzunehmen. Aus der Tabelle bzw. basierend auf einer Formel kann darüberhinaus auch die Zeit bestimmt werden, die abgewartet wird, bis erneut überprüft wird, ob der Spannungsabfall am betroffenen Speichermodul noch vorliegt oder nicht.

Im Schritt S540 wird der Entladestrom dann basierend auf dem bestimmten Entladestrom und/oder der bestimmten Zeit begrenzt. Im Schritt S550 wird ein Zähler n inkrementiert, um festzustellen, wie häufig eine Unregelmäßigkeit aufgetreten ist. Hierbei kann unterschieden werden, ob die Unregelmäßigkeit grundsätzlich für die gesamte Speicheranordnung oder für einzelne Speichermodule festgestellt wurde, was eine Qualitätsaussage für die gesamte Energiespeicheranordnung darstellt. Alternativ bzw. zusätzlich ist es möglich, die Anzahl bzw. Häufigkeit der Feststellung von Unregelmäßigkeiten bezogen auf die einzelnen Speichermodule zu erfassen. Das heißt, in Schritt S550 kann einerseits eine Unregelmäßigkeit überhaupt, d.h. für die gesamte Energiespeicheranordnung erfasst werden bzw. die Häufigkeit der Unregelmäßigkeit für jedes einzelne Speichermodul. Sollte die Unregelmäßigkeit beseitigt sein und der Spannungsabfall wieder im Toleranzbereich bzw. im Normalbereich liegen, wird im Schritt S560 die Begrenzung des Entladestroms aufgehoben und die Strombegrenzungseinheit 30 wird entsprechend von der Steuerungseinrichtung 20 instruiert die Strombegrenzung aufzuheben bzw. wird von der Steuerungseinrichtung 20 ein Signal an die Steuereinheit 41 der Last 40 ausgegeben, um anzuzeigen, dass die Begrenzung aufgehoben wird S570. Danach werden die Speichermodule weiter entladen S580.

Sollte jedoch nach der vorbestimmten Zeit und der Überprüfung in Schritt S560 weiterhin ein Spannungsabfall an dem betroffenen Speichermodul vorliegen, der außerhalb des definierten Bereichs liegt, wird in Schritt S585 überprüft, ob der in Schritt S550 gesetzte Zähler n einem vorbestimmten Wert nₘₐₓ entspricht. Wenn diese vorbestimmte Häufigkeit nₘₐₓ erreicht, ist wird das Entladen beendet, indem die Energiespeicheranordnung 10 von der Last durch die Strombegrenzungseinheit 30 getrennt wird. Sollte der vorbestimmte Wert nₘₐₓ für die maximale Häufigkeit von Unregelmäßigkeiten im Schritt S585 nicht erreicht sein, wird erneut von der Steuerungseinrichtung 20 der Entladestrom bestimmt, in dem beispielsweise über eine Tabelle bzw. über eine Formel berechnet wird, auf welchen Wert der Entladestrom im erneuten Zyklus basierend auf n begrenzt wird. Am einfachsten kann die Begrenzung des Entladestroms immer gleich sein. In entsprechend anspruchsvolleren Systemen ist es möglich, dass bei steigender Häufigkeit von Unregelmäßigkeiten die Höhe der Begrenzung des Entladestroms steigt und/oder auch die Zeit steigt, die abgewartet wird, bis überprüft wird, ob der unnormale Spannungsabfall noch vorliegt.

Insbesondere ist es möglich, den Betrag der Begrenzung oder Absenkung abhängig von der Stärke der Abweichung einzustellen. Außerdem ist es möglich, den Betrag der Begrenzung oder Absenkung abhängig vom absoluten Wert des Entladestroms/Ladestroms einzustellen. Alternativ oder zusätzlich ist es möglich, die Dauer bis zur Überprüfung abhängig vom absoluten Wert des Entladestroms/Ladestroms und/oder von der Stärke der Abweichung einzustellen.

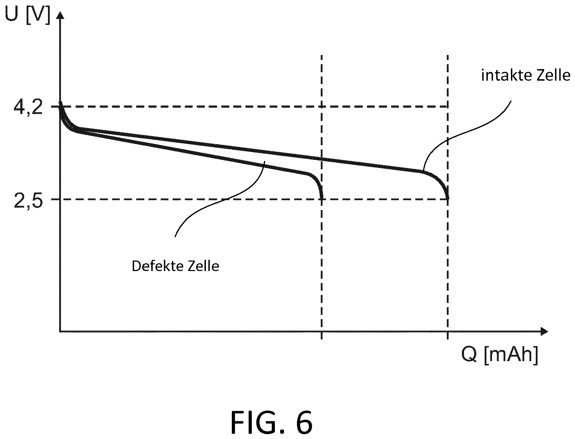

Figur 6 zeigt eine Darstellung, in der die Spannungsverläufe eines intakten und eines defekten Speichermoduls gegenübergestellt sind. Beide Speichermodule haben zu Beginn ihres Entladevorgangs idealerweise die Ladeschlussspannung von 4,2 V. Wenn ein Speichermodul durch ständigen Gebrauch oder extreme Belastung in seiner Leistungsfähigkeit beschränkt ist oder auch defekt ist, wird seine Ladungsfähigkeit reduziert, d.h. das Speichermodul kann nur noch weniger Ladung speichern und erreicht ggf. beim Entladen die Entladeschlussspannung von 2,5 V schneller als das intakte Speichermodul.

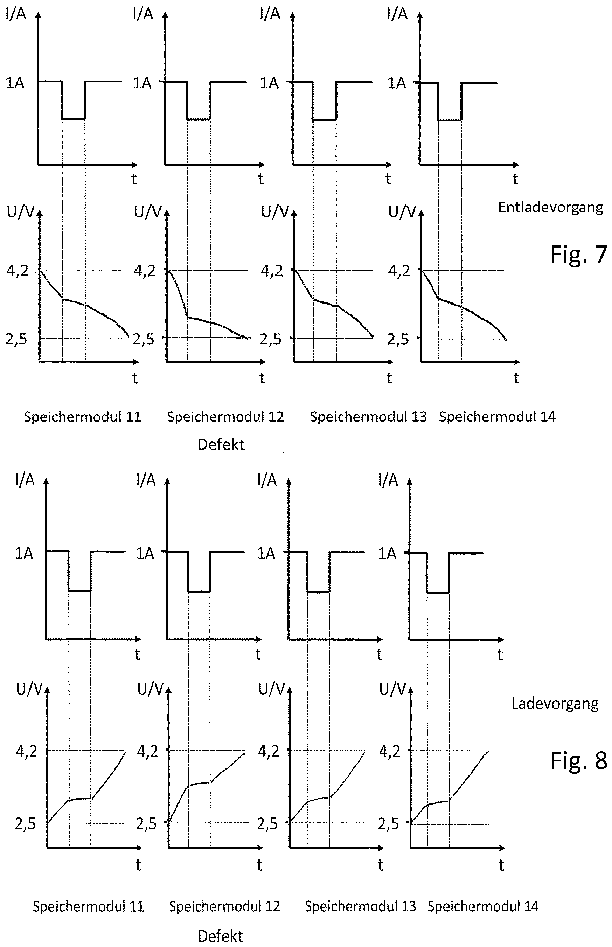

Fig. 7 zeigt den Spannungs- und Stromverlauf beim Entladen einer erfindungsgemäßen Energiespeicheranordnung. Es ist dargestellt, dass die Speichermodule 11, 12, 13 und 14 anfänglich mit 1A entladen werden, wobei die Spannung von einer Ladeschlussspannung bei 4,2 Volt langsam abfällt. Hierbei ist zu erkennen, dass die Spannung bei dem defekten Speichermodul 12 stärker bzw. schneller abfällt als bei den anderen Speichermodulen 11, 13 und 14. Nachdem der schnellere bzw. stärkere Spannungsabfall bei dem Speichermodul 12 erkannt wurde, wird der entnommene Entladestrom in allen Speichermodulen begrenzt, da diese in Reihe geschaltet sind. Es ist erkennbar, dass durch die Begrenzung des Entladestroms, in diesem Fall durch eine Reduzierung auf der Lastseite, der Spannungsabfall in allen Speichermodulen 11, 12, 13 und 14 langsamer wird. Nach einer vorbestimmten Zeit t_{P} wird überprüft, ob im betroffenen Speichermodul 12, der Spannungsabfall wieder im normalen Bereich liegt. Ist der Spannungsabfall in allen Speichermodulen 11, 12, 13 und 14 gleich und im normalen Bereich, konnte die Unregelmäßigkeit folglich durch die Begrenzung des Entladestroms überwunden werden. Dann wird erfindungsgemäß die Begrenzung wieder aufgehoben und der zuvor verwendete Entladestrom zugelassen.

Beim Entladen kann in der Strombegrenzungseinheit 30 ein vollständiges Abschalten vorgenommen werden. Eine Reduzierung des Entladestroms lässt sich hingegen durch ein Signal an die Last 40 bzw. deren Steuereinheit 41 erzielen.

Eine analoge Betrachtung lässt sich für den Ladevorgang vornehmen, der in Figur 8 dargestellt ist. Beim Laden lässt sich die Begrenzung des Ladestroms einerseits durch das Ladegerät 32 vornehmen, welches ein entsprechendes Signal von der Steuerungseinrichtung 20 erhält. Alternativ oder zusätzlich kann die Zufuhr des Ladestroms auch in der Strombegrenzungseinheit 30 durch eine Taktung des zugeführten Ladestroms erfolgen.

Fig. 8 zeigt den Spannungs-/Stromverlauf beim Laden einer erfindungsgemäßen Energiespeicheranordnung. Es ist dargestellt, dass die Speichermodule 11, 12, 13, 14 anfänglich mit 1A geladen werden, wobei die Spannung von einer Entladeschlussspannung von bspw. 2,5 V langsam ansteigt. Sollten die Speichermodule 11, 12, 13, 14 nicht vollständig entladen sein, steigt die Spannung beim Laden von einer Spannung oberhalb der Entladeschlussspannung von 2,5 V an.

Gemäß Figur 8 ist zu erkennen, dass bei dem defekten Speichermodul 12 die Spannung stärker bzw. schneller ansteigt als bei den anderen Speichermodulen 11, 12, 13 und 14. Nachdem der schnellere bzw. stärkere Spannungsanstieg beim Speichermodul 12 durch die Steuerungseinrichtung 20 erkannt wurde, wird der Ladestrom in allen Speichermodulen 11, 12, 13, 14 begrenzt. Dies ist im oberen Bereich der Figur 8 zu erkennen. Im unteren Bereich ist jeweils erkennbar, dass durch die Begrenzung des Ladestroms, bspw. durch entsprechende Einstellung am Ladegerät 32 bzw. durch eine entsprechende Schaltung in der Strombegrenzungseinheit 30, der Spannungsanstieg beim Laden in allen Speichermodulen 11 -14 langsamer wird. Es ist zwar in Figur 8 nicht dargestellt, jedoch gemäß der Erfindung genauso gut möglich, die Zufuhr des Ladestroms bei einer Unregelmäßigkeit für eine gewisse Zeit zu unterbrechen. Während einer Unterbrechung würde die Spannung in den einzelnen Speichermodulen dann nicht mehr ansteigen. Gemäß Fig. 8 ist zu erkennen, dass die Spannung in den einzelnen Speichermodulen während der Begrenzung des Ladestroms nur gering ansteigt. Nach einer vorbestimmten Zeit tₚ wird überprüft, ob im betroffenen Speichermodul 12 der Spannungsanstieg wieder im normalen Bereich liegt, d.h. ob der Spannungsanstieg entweder mit dem Spannungsanstieg in den anderen Speichermodulen 11, 13 und 14 übereinstimmt bzw. mit vorgegebenen Spannungsanstiegswerten übereinstimmt. Wenn der Spannungsanstieg nach der vorbestimmten Zeit tₚ in allen Speichermodulen wieder innerhalb des normalen Bereichs liegt, konnte die Unregelmäßigkeit durch die Begrenzung des Ladestroms überwunden werden. Dann wird die erfindungsgemäße Begrenzung des Ladestroms wieder aufgehoben und der zuvor verwendete Ladestrom zugeführt. Es ist ebenso möglich, danach auch einen reduzierten Ladestrom (bzw. Entladestrom beim Entladen) anzuwenden.

Mit dem vorliegenden erfindungsgemäßen Batteriemanagementsystem bzw. mit dem Verfahren zum Laden oder zum Entladen einer Energiespeicheranordnung lassen sich Unregelmäßigkeiten beim Laden bzw. beim Entladen erkennen. Durch ein erfindungsgemäßes zeitweises Begrenzen bzw. zeitweises Unterbrechen des Lade- bzw. des Entladevorgangs wird eine Möglichkeiten geschaffen, um die Speichermodule der Energiespeicheranordnung zu beruhigen und somit ohne größere technische Eingriffe ein Fortsetzen des Lade- bzw. des Entladevorgangs zu ermöglichen.

Andererseits wird durch das erfindungsgemäße Batteriemanagementsystem sichergestellt, dass im Falle einer andauernden Unregelmäßigkeit die Fortsetzung des Ladens bzw. Entladens unterbrochen wird, wenn nach einer oder mehreren Begrenzungen des Lade- bzw. Entladestroms keine Veränderung im unregelmäßigen oder abweichenden Anstieg bzw. Abfall in der Spannungskurve der Speichermodule zu erkennen ist. Somit wird die Sicherheit beim Laden bzw. Entladen der Energiespeicheranordnung gewährleistet.

## Patentansprüche

1. Batteriemanagementsystem (100) zur Steuerung einer Energiespeicheranordnung (10), die mehrere elektrisch in Reihe geschaltete Speichermodule (11, 12, 13, 14) aufweist, das Batteriemanagementsystem (100) umfasst:
eine Messeinrichtung zur Erfassung wenigstens eines Werts einer physikalischen Größe der Speichermodule (11, 12, 13, 14),
eine Steuerungseinrichtung (20), die geeignet ist, in Abhängigkeit des erfassten Werts einer physikalischen Größe wenigstens eines der Speichermodule (11, 12, 13, 14), beim Entladen einen Entladestrom der den Speichermodulen (11, 12, 13, 14) entnommen wird, zu begrenzen, oder beim Laden einen Ladestrom, der den Speichermodulen (11, 12, 13, 14) zugeführt wird, zu begrenzen, eine Speichereinrichtung (21) zur Speicherung von Werten der erfassten physikalischen Größen und/oder von Veränderungswerten für physikalische Größen der Speichermodule (11, 12, 13, 14),
**dadurch gekennzeichnet, dass** die Steuerungseinrichtung (20) derart eingerichtet ist, den Entladestrom oder den Ladestrom basierend auf einer Überprüfung, ob sich ein Wert einer physikalischen Größe eines der Speichermodule (11, 12, 13, 14) beim Laden oder Entladen schneller verändert, als die entsprechenden Werte der physikalischen Größe der anderen Speichermodule (11, 12, 13, 14) der Energiespeicheranordnung (10), oder ob sich ein Wert einer physikalischen Größe eines der Speichermodule (11, 12, 13, 14) schneller verändert als ein in der Speichereinrichtung gespeicherter Veränderungswert für die physikalische Größe, zu begrenzen, und
wobei die Steuerungseinrichtung (20) derart eingerichtet ist,
die Ladestrombegrenzung oder die Entladestrombegrenzung zu verringern, wenn die Veränderung des Werts der physikalischen Größe des entsprechenden Speichermoduls (11, 12, 13, 14) nicht mehr von den Veränderungswerten der physikalischen Größe der anderen Speichermodule abweicht oder einen vorbestimmten Veränderungswert der physikalischen Größe erreicht.

2. Batteriemanagementsystem nach Anspruch 1, wobei die Steuerungseinrichtung (20) den Entladestrom und/oder Ladestrom basierend auf einem Vergleich des wenigstens einen erfassten Wertes der physikalischen Größe von wenigstens einem der Speichermodule (11, 12, 13, 14) mit einem in der Speichereinrichtung (21) gespeicherten Wert der physikalischen Größe der Speichermodule und/oder basierend auf einem Vergleich mit einem vorgegebenen Veränderungswert für die physikalische Größe steuert.

3. Batteriemanagementsystem nach einem der vorhergehenden Ansprüche, wobei die Messeinrichtung die Spannung, den Strom und/oder die Temperatur der Speichermodule (11, 12, 13, 14) als physikalische Größe erfasst.

4. Batteriemanagementsystem nach einem der vorhergehenden Ansprüche, wobei die Steuerungseinrichtung (20) bei einer Abweichung beim Entladen ein Signal an eine externe Steuereinheit (41) zur Beeinflussung des Entladestroms ausgibt oder beim Laden ein Signal an ein Ladegerät (32) zur Beeinflussung des zugeführten Ladestroms ausgibt.

5. Batteriemanagementsystem nach einem der vorhergehenden Ansprüche, wobei das Batteriemanagementsystem (100) an eine Strombegrenzungseinheit (30) gekoppelt ist oder eine Strombegrenzungseinheit (30) aufweist, wobei die Strombegrenzungseinheit (30) in Abhängigkeit von Steuersignalen der Steuerungseinrichtung (20) aktiviert und/oder deaktiviert wird, um den Ladestrom und/oder Entladestrom, der den Speichermodulen (11, 12, 13, 14) der Energiespeicheranordnung (10) zugeführt oder entnommen wird, zu begrenzen.

6. Batteriemanagementsystem nach einem der vorhergehenden Ansprüche, wobei die Steuerungseinrichtung (20) überprüft, ob sich ein Spannungswert eines der Speichermodule (11, 12, 13, 14) schneller verändert als die Spannungswerte der anderen Speichermodule (11, 12, 13, 14) der Energiespeicheranordnung (10) oder ob sich ein Spannungswert eines der Speichermodule (11, 12, 13, 14) schneller verändert als ein in der Speichereinrichtung (21) gespeicherter Spannungsveränderungswert.

7. Batteriemanagementsystem nach Anspruch 6, wobei die Steuerungseinrichtung (20) bei einer Abweichung der Spannungsänderung an einem der Speichermodule (11, 12, 13, 14) eine Ladestrombegrenzung oder eine Entladestrombegrenzung für alle Speichermodule (11, 12, 13, 14) aktiviert.

8. Batteriemanagementsystem nach Anspruch 6 oder 7, wobei die Steuerungseinrichtung (20) die Ladestrombegrenzung oder Entladestrombegrenzung deaktiviert, wenn die Spannungsänderung des entsprechenden Speichermoduls (11, 12, 13, 14) nicht mehr von den Spannungsänderungswerten der anderen Speichermodule abweicht oder einen vorbestimmten Spannungsänderungswert erreicht.

9. Batteriemanagementsystem nach Anspruch 6 oder 7, wobei die Steuerungseinrichtung (20) die Ladestrombegrenzung oder Entladestrombegrenzung verringert, wenn die Spannungsänderung des entsprechenden Speichermoduls (11, 12, 13, 14) nicht mehr von den Spannungsänderungswerten der anderen Speichermodule abweicht oder einen vorbestimmten Spannungsänderungswert erreicht.

10. Batteriemanagementsystem nach einem der vorhergehenden Ansprüche, wobei in der Speichereinrichtung (21) für verschiedene Ladestromwerte und/oder Entladestromwerte verschiedene Spannungsändenmgswerte gespeichert sind.

11. Batteriemanagementsystem nach einem der vorhergehenden Ansprüche, wobei die Anzahl (n) von Abweichungen in einem Speichermodul zu den anderen Speichermodulen (11, 12, 13, 14) oder zu gespeicherten Werten erfasst und bei der Steuerung der Ladestrom- und/oder Entladestrombegrenzung berücksichtigt wird.

12. Batteriemanagementsystem nach einem der vorhergehenden Ansprüche, wobei die Größe der der Ladestrom- und/oder Entladestrombegrenzung abhängig vom zugeführten Ladestrom oder Entladestrom eingestellt wird.

13. Batteriemanagementsystem nach einem der vorhergehenden Ansprüche, wobei die Dauer zur Überprüfung, ob sich ein Speichermodul mit einer festgestellten Abweichung einer physikalischen Größe wieder normal verhält, abhängig vom zugeführten Ladestrom oder Entladestrom und/oder vom absoluten Wert der festgestellten Abweichung eingestellt wird.

14. Energiespeicheranordnung mit mehreren elektrisch in Reihe geschalteten Speichermodulen (11, 12, 13, 14) und einem Batteriemanagementsystem (100) nach einem der Ansprüche 1 bis 13.

15. Verfahren zum Laden oder Entladen einer Energiespeicheranordnung (10), die mehrere elektrisch in Reihe geschaltete Speichermodule (11, 12, 13, 14) aufweist, umfassend die Schritte:
Erfassen (S210, S410) wenigstens eines Werts einer physikalischen Größe der Speichermodule (11, 12, 13, 14),
Überprüfen (S220, S420), ob sich ein Wert einer physikalischen Größe eines der Speichermodule (11, 12, 13, 14) beim Laden oder Entladen schneller verändert, als ein entsprechender Wert einer physikalischen Größe der anderen Speichermodule (11, 12, 13, 14) der Energiespeicheranordnung (10) und/oder ob sich ein Wert einer physikalischen Größe eines der Speichermodule (11, 12, 13, 14) schneller verändert als ein in einer Speichereinrichtung abgespeicherter Veränderungswert für die physikalische Größe;
und **gekennzeichnet durch** die Schritte:
Begrenzen (S230, S430) des Ladestroms beim Laden, der den Speichermodulen (11, 12, 13, 14) zugeführt wird, basierend auf der Überprüfung oder
Begrenzen (S230, S430) des Entladestroms beim Entladen, der den Speichermodulen (11, 12, 13, 14) entnommen wird, basierend auf der Überprüfung,
Verringern der Begrenzung des Ladestroms beim Laden oder Verringern der Begrenzung des Entladestroms bei Entladen, wenn die Veränderung des Werts der physikalischen Größe des entsprechenden Speichermoduls (11, 12, 13, 14) nicht mehr von den Veränderungswerten der physikalischen Größe der anderen Speichermodule abweicht oder einen vorbestimmten Veränderungswert der physikalischen Größe erreicht.

## Claims

1. Battery management system (100) for controlling an energy storage assembly (10), which has a plurality of storage modules (11, 12, 13, 14) electrically connected in series, wherein the battery management system (100) comprises:
a measuring device for detecting at least one value of a physical quantity of the storage modules (11, 12, 13, 14),
a control device (20), which is suitable for limiting a discharging current drawn from the storage modules (11, 12, 13, 14) during discharging, as a function of the detected value of a physical quantity of at least one of the storage modules (11, 12, 13, 14),
or for limiting a charging current supplied to the storage modules (11, 12, 13, 14) when charging,
a storage device (21) for storing values of the detected physical quantities and/or change values for physical quantities of the storage modules (11, 12, 13, 14),
**characterized in that**
the control device (20) is configured so as to limit the discharge current or the charging current, based on a check of whether a value of a physical quantity of one of the storage modules (11, 12, 13, 14) changes more quickly during charging or discharging than the corresponding values of the physical quantity of the other storage modules (11, 12, 13, 14) of the energy storage assembly (10), or whether a value of a physical quantity of one of the storage modules (11, 12, 13, 14) changes more quickly than a change value stored in the storage device for the physical quantity, and
wherein the control device (20) is configured in such a way as to reduce the charging current limitation or the discharge current limitation, if the change in the value of the physical quantity of the corresponding storage module (11, 12, 13, 14) no longer differs from the change values of the physical quantity of the other storage modules or reaches a predefined change value of the physical quantity.

2. Battery management system according to Claim 1,
wherein the control device (20) controls the discharge current and/or charging current based on a comparison of the at least one measured value of the physical quantity of at least one of the storage modules (11, 12, 13, 14) with a value, stored in the storage device (21), of the physical quantity of the storage modules and/or based on a comparison with a predefined change value for the physical quantity.

3. Battery management system according to any one of the preceding claims, wherein the measuring device detects the voltage, the current and/or the temperature of the storage modules (11, 12, 13, 14) as the physical quantity.

4. Battery management system according to any one of the preceding claims, wherein the control device (20), in the event of a deviation, outputs a signal to an external control unit (41) during discharging to affect the discharge current, or during charging outputs a signal to a charging unit (32) to affect the supplied charging current.

5. Battery management system according to any one of the preceding claims, wherein the battery management system (100) is coupled to a current limiting unit (30) or comprises a current limiting unit (30), wherein the current limiting unit (30) is activated and/or deactivated depending on control signals from the control device (20), in order to limit the charging current and/or discharge current that is supplied to or drawn from the storage modules (11, 12, 13, 14) of the energy storage assembly (10).

6. Battery management system according to any one of the preceding claims, wherein the control device (20) checks whether a voltage value of one of the storage modules (11, 12, 13, 14) changes more quickly than the voltage values of the other storage modules (11, 12, 13, 14) of the energy storage assembly (10), or whether a voltage value of one of the storage modules (11, 12, 13, 14) changes more quickly than a voltage change value stored in the storage device (21).

7. Battery management system according to Claim 6, wherein the control device (20), in the event of a deviation of the voltage change in one of the storage modules (11, 12, 13, 14), activates a charging current limitation or a discharge current limitation for all storage modules (11, 12, 13, 14).

8. Battery management system according to Claim 6 or 7, wherein the control device (20) deactivates the charging current limitation or discharge current limitation if the voltage change of the corresponding storage module (11, 12, 13, 14) no longer differs from the voltage change values of the other storage modules, or reaches a predefined voltage change value.

9. Battery management system according to Claim 6 or 7, wherein the control device (20) reduces the charging current limitation or discharge current limitation if the voltage change of the corresponding storage module (11, 12, 13, 14) no longer differs from the voltage change values of the other storage modules, or reaches a predefined voltage change value.

10. Battery management system according to any one of the preceding claims, wherein different voltage change values are stored in the storage device (21) for different charging current values and/or discharge current values.

11. Battery management system according to any one of the preceding claims, wherein the number (n) of deviations in a storage module relative to the other storage modules (11, 12, 13, 14) or to stored values is detected and taken into account in the control of the limitation of the charging current and/or discharge current.

12. Battery management system according to any one of the preceding claims, wherein the size of the charge current and/or discharge current limitation is adjusted depending on the supplied charging or the discharge current.

13. Battery management system according to any one of the preceding claims, wherein the time required to check whether a storage module with a detected deviation of a physical quantity is behaving normally again is adjusted depending on the supplied charging current or discharge current and/or on the absolute value of the detected deviation.

14. Energy storage assembly with a plurality of storage modules (11, 12, 13, 14) electrically connected in series and with a battery management system (100) according to any one of Claims 1 to 13.

15. Method for charging or discharging an energy storage assembly (10), which has a plurality of storage modules electrically connected in series (11, 12, 13, 14), comprising the steps:
detecting (S210, S410) at least one value of a physical quantity of the storage modules (11, 12, 13, 14),
checking (S220, S420) whether or not a value of a physical quantity of one of the storage modules (11, 12, 13, 14) changes more quickly during charging or discharging than a corresponding value of a physical quantity of the other storage modules (11, 12, 13, 14) of the energy storage assembly (10) and/or whether a value of a physical quantity of one of the storage modules (11, 12, 13, 14) changes more quickly than a change value for the physical quantity stored in a storage device;
and **characterized by** the steps:
limiting (S230, S430) the charging current which is supplied to the storage modules (11, 12, 13, 14) during charging based on the check, or
limiting (S230, S430) the discharge current which is drawn from the storage modules (11, 12, 13, 14) during discharging, based on the check,
reducing the limitation of the charging current during charging or reducing the limitation of the discharge current during discharging, if the change in the value of the physical quantity of the corresponding storage module (11, 12, 13, 14) no longer differs from the change values of the physical quantity of the other storage modules or reaches a predefined change value of the physical quantity.

## Revendications

1. Système de gestion de batterie (100) pour commander un ensemble d'accumulation d'énergie (10) qui présente plusieurs modules d'accumulation (11, 12, 13, 14) connectés électriquement en série, le système de gestion de batterie (100) comprenant :
un dispositif de mesure pour détecter au moins une valeur d'une grandeur physique des modules d'accumulation (11, 12, 13, 14),
un dispositif de commande (20) qui convient pour, en fonction de la valeur détectée d'une grandeur physique d'au moins l'un des modules d'accumulation (11, 12, 13, 14), limiter, lors de la décharge, un courant de décharge prélevé des modules d'accumulation (11, 12, 13, 14), ou pour, lors de la charge, limiter un courant de charge amené aux modules d'accumulation (11, 12, 13, 14),
un dispositif d'enregistrement (21) pour l'enregistrement de valeurs des grandeurs physiques détectées et/ou de valeurs de variation pour des grandeurs physiques des modules d'accumulation (11, 12, 13, 14),
**caractérisé en ce que** le dispositif de commande (20) est étudié de telle sorte à limiter le courant de décharge ou le courant de charge sur la base d'une vérification si une valeur d'une grandeur physique de l'un des modules d'accumulation (11, 12, 13, 14) varie plus rapidement pendant la charge ou la décharge que les valeurs correspondantes de la grandeur physique des autres modules d'accumulation (11, 12, 13, 14) de l'ensemble d'accumulation d'énergie (10), ou bien si une valeur d'une grandeur physique de l'un des modules d'accumulation (11, 12, 13, 14) varie plus rapidement qu'une valeur de variation pour la grandeur physique enregistrée dans le dispositif d'enregistrement, et
dans lequel le dispositif de commande (20) est étudié de telle sorte à réduire la limitation du courant de charge ou la limitation du courant de décharge si la variation de la valeur de la grandeur physique du module d'accumulation (11, 12, 13, 14) correspondant ne diverge plus par rapport aux valeurs de variation de la grandeurs physique des autres modules d'accumulation ou atteint une valeur de variation prédéfinie de la grandeur physique.

2. Système de gestion de batterie selon la revendication 1, dans lequel le dispositif de commande (20) assure la commande du courant de décharge et/ou du courant de charge sur la base d'une comparaison de l'au moins une valeur détectée de la grandeur physique d'au moins l'un des modules d'accumulation (11, 12, 13, 14) avec une valeur de la grandeur physique enregistrée dans le dispositif d'enregistrement (21) et/ou sur la base d'une comparaison avec une valeur de variation prescrite pour la grandeur physique.

3. Système de gestion de batterie selon l'une des revendications précédentes, dans lequel le dispositif de mesure détecte la tension, le courant et/ou la température des modules d'accumulation (11, 12, 13, 14) en tant que grandeur physique.

4. Système de gestion de batterie selon l'une des revendications précédentes, dans lequel, en cas d'une divergence lors de la décharge, le dispositif de commande (20) émet un signal à l'attention d'une unité de commande externe (41) pour influencer le courant de décharge ou émet, lors de la charge, un signal à l'attention d'un appareil de charge (32) pour influencer le courant de charge amené.

5. Système de gestion de batterie selon l'une des revendications précédentes, dans lequel le système de gestion de batterie (100) est couplé avec une unité de limitation de courant (30) ou présente une unité de limitation de courant (30), dans lequel l'unité de limitation de courant (30) est activée et/ou désactivée en fonction de signaux de commande du dispositif de commande (20) pour limiter le courant de charge et/ou le courant de décharge qui est amené aux modules d'accumulation (11, 12, 13, 14) de l'ensemble d'accumulation d'énergie (10) ou est prélevé à partir de ceux-ci.

6. Système de gestion de batterie selon l'une des revendications précédentes, dans lequel le dispositif de commande (20) vérifie si une valeur de tension de l'un des modules d'accumulation (11, 12, 13, 14) varie plus rapidement que les valeurs de tension des autres modules d'accumulation (11, 12, 13, 14) de l'ensemble d'accumulation d'énergie (10) ou si une valeur de tension de l'un des modules d'accumulation (11, 12, 13, 14) varie plus vite qu'une valeur de variation de tension enregistrée dans l'unité d'enregistrement (21).

7. Système de gestion de batterie selon la revendication 6, dans lequel, en cas de divergence de la variation de tension au niveau de l'un des modules d'accumulation (11, 12, 13, 14), le dispositif de commande (20) active une limitation du courant de charge ou une limitation du courant de décharge pour tous les modules d'accumulation (11, 12, 13, 14).

8. Système de gestion de batterie selon la revendication 6 ou 7, dans lequel le dispositif de commande (20) désactive la limitation du courant de charge ou la limitation du courant de décharge si la variation de tension du module d'accumulation (11, 12, 13, 14) correspondant ne diverge plus par rapport aux valeurs de variation de tension des autres modules d'accumulation ou atteint une valeur de variation de tension prédéfinie.

9. Système de gestion de batterie selon la revendication 6 ou 7, dans lequel le dispositif de commande (20) réduit la limitation du courant de charge ou la limitation du courant de décharge si la variation de tension du module d'accumulation (11, 12, 13, 14) correspondant ne diverge plus par rapport aux valeurs de variation de tension des autres modules d'accumulation ou atteint une valeur de variation de tension prédéfinie.

10. Système de gestion de batterie selon l'une des revendications précédentes, dans lequel on enregistre dans le dispositif d'enregistrement (21), pour différentes valeurs de courant de charge et/ou de valeurs de courant de décharge, différentes valeurs de variation de tension.

11. Système de gestion de batterie selon l'une des revendications précédentes, dans lequel le nombre (n) de divergences dans un module d'accumulation par rapport aux autres modules d'accumulation (11, 12, 13, 14) ou par rapport à des valeurs enregistrées est détecté et est pris en compte lors de la commande de la limitation du courant de charge et/ou du courant de décharge.

12. Système de gestion de batterie selon l'une des revendications précédentes, dans lequel l'ampleur de la limitation du courant de charge et/ou du courant de décharge est réglée en fonction du courant de charge amené ou du courant de décharge.

13. Système de gestion de batterie selon l'une des revendications précédentes, dans lequel la durée pour vérifier si un module d'accumulation avec une divergence constatée d'une grandeur physique se comporte de nouveau normalement est réglée en fonction du courant de charge amené ou du courant de décharge et/ou de la valeur absolue de la divergence constatée.

14. Ensemble d'accumulation d'énergie avec plusieurs modules d'accumulation (11, 12, 13, 14) connectés électriquement en série et un système de gestion de batterie (100) selon l'une des revendications 1 à 13.

15. Procédé pour charger ou décharger un ensemble d'accumulation d'énergie (10) qui présente plusieurs modules d'accumulation (11, 12, 13, 14) connectés électriquement en série, comprenant les étapes suivantes :
la détection (S210, S410) d'au moins une valeur d'une grandeur physique des modules d'accumulation (11, 12, 13, 14),
la vérification (S220, S420) si une valeur d'une grandeur physique de l'un des modules d'accumulation (11, 12, 13, 14) varie plus vite lors de la charge ou la décharge qu'une valeur correspondante d'une grandeur physique des autres modules d'accumulation (11, 12, 13, 14) de l'ensemble d'accumulation d'énergie (10) et/ou si une valeur d'une grandeur physique de l'un des modules d'accumulation (11, 12, 13, 14) varie plus vite qu'une valeur de variation pour la grandeur physique enregistrée dans un dispositif d'enregistrement ;
et **caractérisé par** les étapes suivantes :
la limitation (S230, S430) du courant de charge lors de la charge, lequel est amené aux modules d'accumulation (11, 12, 13, 14), sur la base de la vérification, ou
la limitation (S230, S430) du courant de décharge lors de la décharge, lequel est prélevé des modules d'accumulation (11, 12, 13, 14), sur la base de la vérification,
la réduction de la limitation du courant de charge lors de la charge ou la réduction de la limitation du courant de décharge lors de la décharge si la variation de la valeur de la grandeur physique du module d'accumulation (11, 12, 13, 14) correspondant ne diverge plus par rapport aux valeurs de variation de la grandeur physique des autres modules d'accumulation ou atteint une valeur de variation prédéfinie de la grandeur physique.
